# EUROPEAN PATENT SPECIFICATION

(11) **EP 0 980 007 B1**
(45) Date of publication and mention of the grant of the patent: **18.06.2003**
(21) Application number: 98306379.3
(22) Date of filing: 10.08.1998
(51) Int. Cl.: G01R 31/36, H04B 5/06

(54) **Transmitter battery life indication apparatus and method**
Gerät und Verfahren zur Anzeige der Lebensdauer einer Senderbatterie
Appareil et procédé de signalisation de l'état de charge de la batterie d'un émetteur

(43) Date of publication of application: 16.02.2000
(73) Proprietor: Shure Incorporated, Evanston, IL 60202 (US)
(72) Inventor: Grad, Steven M., Deerfield, Illinois 60015 (US)
(74) Representative: Bizley, Richard Edward

(56) References cited:
- DE-A- 4 340 448
- US-A- 4 484 354
- US-A- 4 737 784
- US-A- 4 910 795
- PATENT ABSTRACTS OF JAPAN vol. 16, no. 408 (E-1255), 28 August 1992 & JP 04 135398 A (TAMURA SEISAKUSHO), 8 May 1992 & JP 04 135398 A

## Description

### BACKGROUND OF THE INVENTION

### A. Field of the Invention

This invention relates to the field of wireless microphone systems having a battery-operated transmitter and a receiver.

### B. Description of Related Art

In the art of wireless microphones, a microphone transmitter is positioned at a location to receive acoustic waves from a desired sound source and responsively transmit the acoustic information to a receiver via high frequency radio signals. Often, such transmitters are powered by a replaceable batteries, such as a 9 volt battery or two "AA" batteries.

Many modern wireless microphones incorporate a circuit that generates a tone having a frequency above the audible limit. This tone is used for what is known in the art as "tone coded squelch" or "tone key". When this feature is implemented, the receiver searches for the high frequency tone with suitable tone detection circuitry, and will not unsquelch the receiver until the tone is detected. In essence, the receiver is in an "OFF" condition until it detects the presence of the high frequency tone (indicating that the transmitter is active and transmitting acoustic information), whereupon the receiver is switched into an "ON" condition.

The tone may, for example, be a 32.768 Khz (or 32768 HZ) sine wave that is crystal-controlled by a standard 32.768 Khz watch crystal. The present invention takes advantage of the existing 32.768 KHz tone generated by the transmitter, and uses it to provide a means in the receiver for indicating the status of the battery in the transmitter. Using the techniques of the present invention, the battery level of the transmitter may be monitored such that a low battery indicator is activated at the receiver if the transmitter battery voltage falls to a predetermined threshold level. Alternatively, the invention provides for the implementation of a battery "fuel gauge", providing essentially a continued monitoring of the battery voltage as it lowers toward a level requiring battery replacement. This feature permits the user of the system to monitor the transmitter battery's life and schedule a battery replacement for a convenient time, and avoid a battery failure from occurring unexpectedly at a critical moment. These and other advantages and features of the invention will become apparent from the following detailed description of preferred and alternative embodiments of the invention.

US Patent No. 5,737,784 (Hirano) discloses a keyless entry system that can lock and unlock an automotive vehicle door, a trunk lid, a glove box and/or a steering column without an ignition key. The system comprises a transmitter producing a radio signal indicative of a preset unique code, and a controller receiving the radio signal and performing desired locking or unlocking operation when the code from the transmitter matches a preset code. A manual switch is provided to order the transmitter to transmit the code-indicative radio signal to the controller. The transmitter encloses a battery acting as a power source. The patent has relevance to the present patent application because it discloses a battery checker that is located at the transmitter and that produces an alarm at the controller when the battery voltage becomes lower than a predetermined voltage.

### Summary of the Invention

The present invention is implemented in a system comprising a transmitter (such as a wireless microphone transmitter) having a battery, and a receiver. In a first aspect, there is provided a method of determining the status of a battery in a system comprising a transmitter and a receiver, the transmitter having the battery and the method characterised by the steps of: transmitting a tone from said transmitter to said receiver, said tone having a first amplitude associated with said battery being in a normal condition; changing the amplitude of said tone from said first amplitude to a second amplitude when the condition of said battery changes; receiving said tone with said receiver; detecting said change in amplitude of said tone; and responsively alerting a user of said system of the battery condition of said battery with a quantitative indicator when said amplitude of said tone changes.

Preferably, the step of changing the amplitude comprises the step of lowering the amplitude of the tone. The tone is typically generated by a tone oscillator, and the step of changing the amplitude of said tone preferably comprises the step of changing the amplitude of the output signal from the tone oscillator, such as by switching in or out a resistor to thereby lower the voltage of the output signal from the tone oscillator, or by decreasing the voltage level which the oscillator is operating from.

In a microphone application, the tone generated by the tone oscillator comprises a sine wave having a frequency above the audible limit of a human, for example, a 32.768 Khz sine wave produced by a clock crystal oscillator that is used to unsquelch the receiver. Thus, the invention may take advantage of existing tone generation circuitry in the transmitter and use the tone to indicate the status of the transmitter battery in the receiver.

### BRIEF DESCRIPTION OF THE DRAWINGS

The presently preferred embodiment of the invention will be described in conjunction with the accompanying drawings, wherein like reference numerals refer to like elements in the various views, and wherein
FIG. 1 is an overall block diagram of the transmitter battery and tone oscillator circuitry according to a preferred embodiment of the invention;
FIG. 2 is a circuit diagram of a portion of the transmitter of FIG. 1 with an alternate method for changing the tone key amplitude;
FIG. 3 is a circuit diagram of the tone detection circuitry of the receiver;
FIG. 4 is a circuit diagram of the alternate low battery detection circuitry of FIG. 3;
FIG. 5 is a circuit diagram of the tone oscillator circuit of FIG. 1;
FIG. 6 is a circuit diagram of the buffer/filter portion of the tone oscillator circuit of FIG. 5, showing the first generation circuit for changing the amplitude of the high frequency tone as in the case of a low battery condition;
FIG. 7 is a circuit diagram of the buffer/filter portion of the tone oscillator circuit of FIG. 5, showing another alternative circuit for changing the amplitude of the tone;
FIG. 8 is a block diagram of the battery and microcontroller for the embodiments of FIG. 2, FIG. 6 and FIG. 7; and
FIG. 9 is a block diagram of an alternative arrangement for the circuit of FIG. 6 and FIG. 7.
FIG. 10 is a block diagram of the preferred low battery detection/fuel gauge display circuitry of the receiver.

### DESCRIPTION OF THE PREFERRED AND ALTERNATIVE EMBODIMENTS OF THE INVENTION

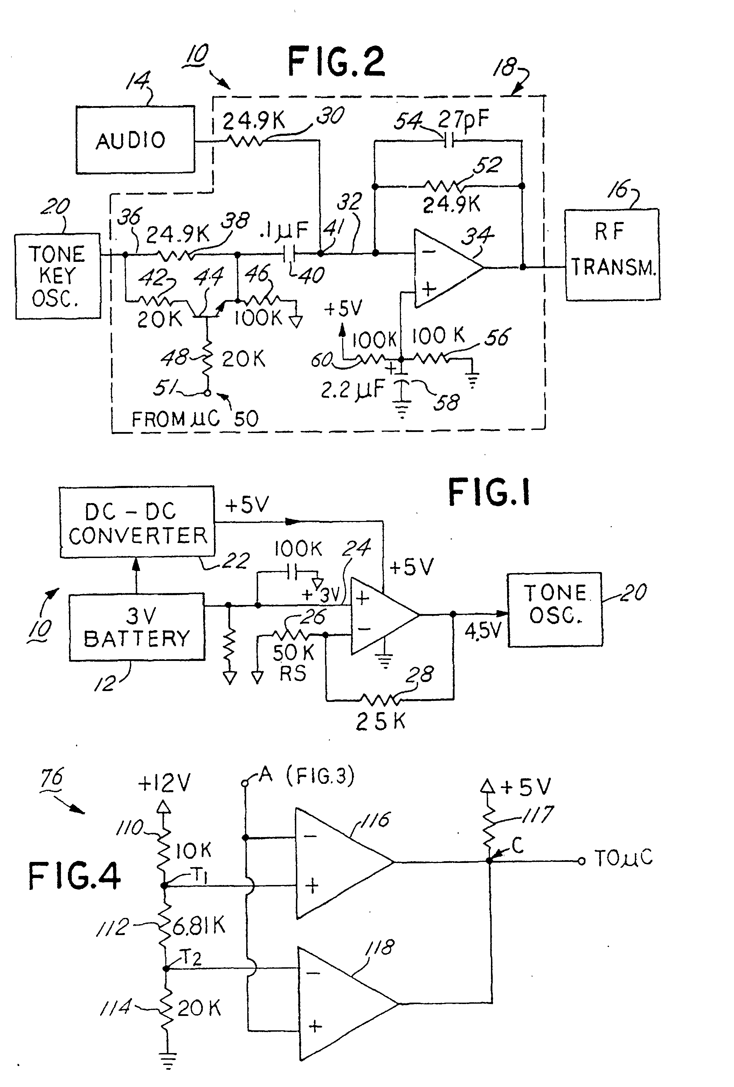

Referring now to FIG. 1 and FIG. 2, the transmitter 10 is shown in block diagram form. The transmitter 10 includes a battery 12, an audio circuit 14, a radio frequency (RF) transmitter 16, a summing amplifier 34, and a tone oscillator 20. The transmitter battery 12 may be, for example, a 9 volt replaceable or 2 "AA" batteries. A DC-DC converter 22 steps up the battery voltage from 3 volts to a constant 5 volts, which is supplied to an amplifier 24. The battery 12 is also connected to the positive terminal of amplifier 24. Resistor 26 connects to the negative terminal of the amplifier 24 and ground. A feedback resistor 28 is placed across the negative terminal of the amplifier and the amplifier output, resulting in an amplifier gain of 1 1/2, thereby producing a 4.5 volt supply to the tone oscillator 20, for a 3V battery voltage.

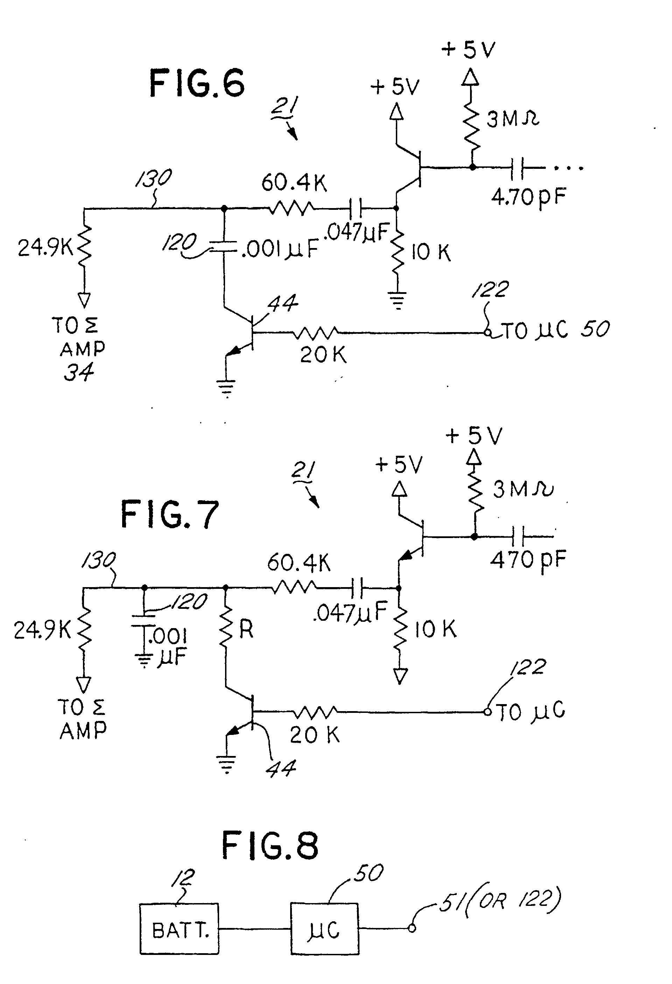

Thus, it can be seen from FIG. 1 that in a preferred embodiment of the invention the tone oscillator 20 is run off the voltage from battery 12, which automatically causes a gradual lowering of the amplitude of the 32.768 Khz tone signal produced by the tone oscillator 20 as the supply voltage from batter 12 lowers with time. This will allow for more levels of battery status indication in the microphone receiver. Further, the stepping up of the battery voltage from 3 volts to 4.5 volts essentially magnifies or increases the "dynamic range" of the battery voltage status indication in the microphone receiver. It will be understood, however, that if a higher voltage battery is used, e.g. 9 volts, the stepping of voltage may not be needed, and in fact a step down to 4.5 volts could be used. Furthermore, the invention may be implemented by reducing the amplitude in alternate ways, as will be apparent from FIG. 2 and FIG. 8 and the following discussion.

When the oscillator 20 is supplied by the battery 12 via the dc amplifier, as the voltage level of the battery 12 goes down, so does the 4.5 volt supply to the tone oscillator 20, while the 5 volts supplied to the amplifier 24 stays the same. Amplifying the 3 volts up to 4.5 volts insures that the oscillator 20 will start up at low battery conditions. For example, if the battery 12 voltage falls to 2 volts, 3 volts are supplied to tone oscillator 20, which is enough for the tone oscillator 20 to operate.

Referring now to FIG. 2 and FIG. 8, alternate amplitude reduction methods will be described in greater detail. The audio circuit 14 is responsive to voice or other sounds and sends an output audio signal through resistor 30 onto an input conductor 32 to a summing amplifier 34. The output of the tone oscillator 20 is a 32.768 kHz sine wave of a given first amplitude. In a preferred mode, if the tone oscillator 20 is powered by the battery 12 via the dc amplifier, this amplitude will gradually lower with time as noted above. The tone from tone oscillator 20 is placed on conductor 36. A resistor 38 and capacitor 40 are placed in series between conductor 36 and conductor 32. In an alternate mode, a resistor 42 and transistor 44 are placed in parallel with resistor 38. A microcontroller 50 is connected to the base of transistor 44 via node 51 and resistor 48. The audio and 32.768 KHz tone are added together at summing node 41. A resistor 46 is placed between the emitter of transistor 44 and ground. The summing amplifier 34 includes a feedback circuit comprising resistor 52 and capacitor 54 in parallel. Resistors 60 and 56 and capacitor 58 are connected between positive terminal of summing amplifier 34 and ground, and supply a half supply bias for the amp stage. The output voltage of summing amplifier 34 is supplied to a conventional RF transmitter 16 (FM modulation) where the combined audio and tone key signal are transmitted to the receiver.

As shown in FIG. 8, the microcontroller 50 (such as Part No. MC68HC705LS from _Motorola) is connected to the battery 12. When the battery 12 is substantially fully charged (i.e. "good"), the output signal from the microcontroller 50 at node 51 is a logic high (i.e., 5 volts). When the battery voltage drops below a threshold level, the microcontroller 50 sends a logic low signal to node 51. When a high signal is provided at node 51, the transistor is in an "ON" condition, causing current to flow through resistor 42. Due to the parallel current path through resistors 38 and 42 when the battery is in a good or normal condition, the amplitude of the oscillator that is transmitted is relatively high due to the higher gain in the summing amplifier 34. But when the transistor 44 is off, as in the case when the battery level falls below a threshold level and a logic low signal is input to the base of the transistor 44, resistor 42 is switched out of the circuit, causing the transmitted amplitude of the tone from the tone oscillator 20 to drop appreciably due to the reduction in gain of amplifier 34. When this change in amplitude is detected at the receiver, an indicator may be activated indicating a low battery condition in the transmitter.

In the event that a microcontroller 50 changes the signal level at node 51 too quickly, an audible "pop" may be induced into the RF transmitter's signal. This may be fixed by adding a capacitor that would slow down the turning "ON" and "OFF" of the transistor 44. For example, a capacitor could be added from the base of transistor 44 to ground.

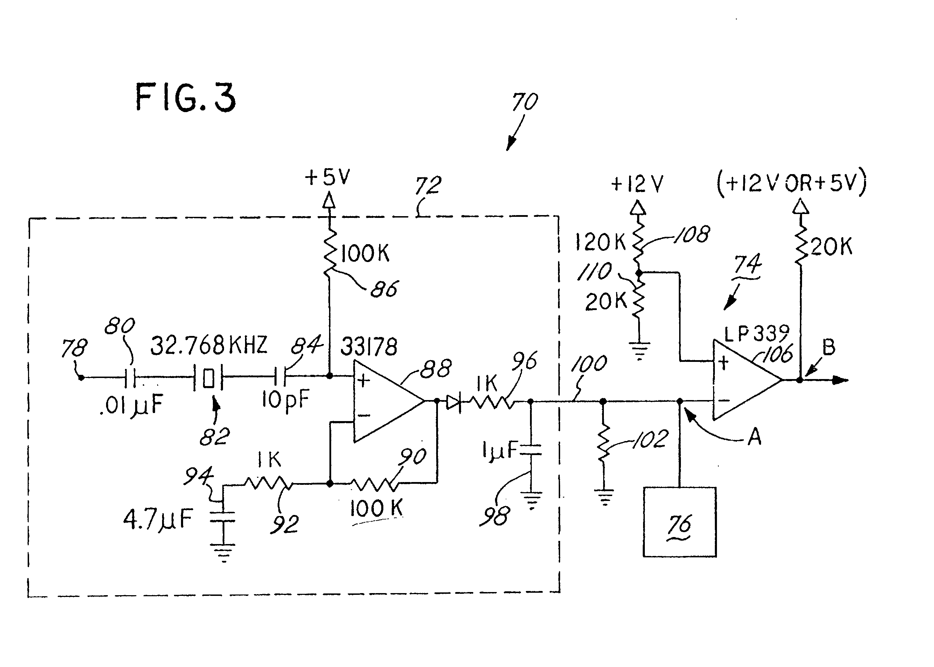

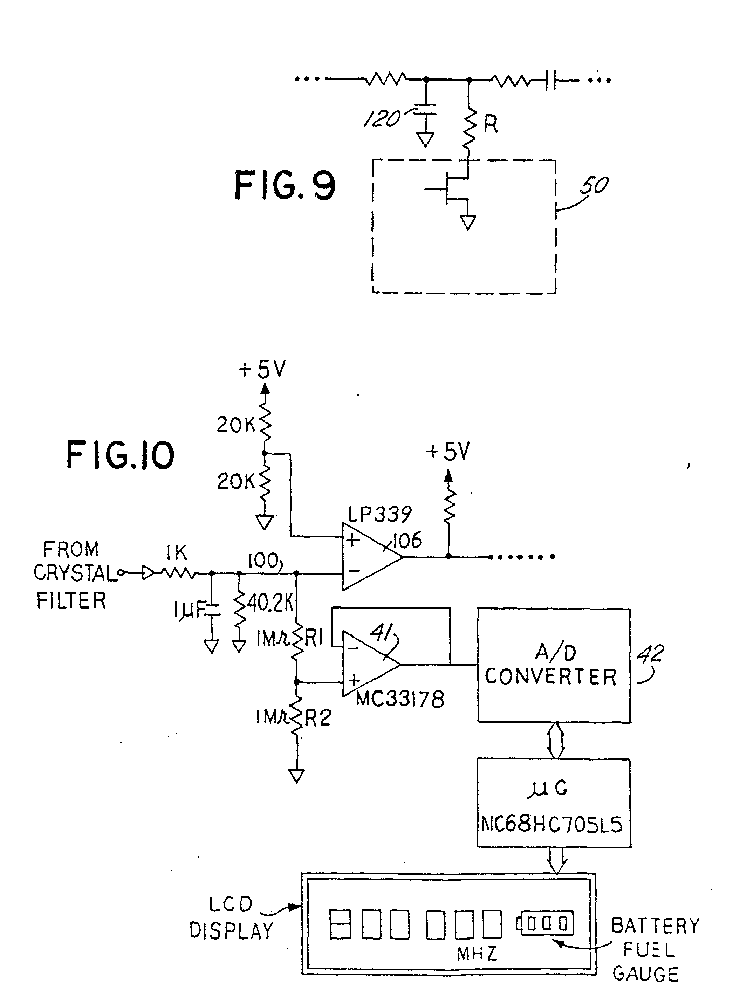

Referring now to FIG. 3 and FIG. 10, the pertinent portions of the receiver for the microphone transmitter 10 are shown in detail. The receiver includes a tone detection circuit 70, shown in circuit diagram form. The tone detection circuit 70 consists of an opamp crystal filter circuit 72 (with the same clock crystal as was used in the tone oscillator 20), and a peak detect and comparator circuit 74. A low-battery detector circuit is also provided and is shown in block diagram form in FIG. 10.

The crystal filter circuit 72 receives demodulated voltage signals from a conventional FM receiver circuit (not shown) at point 78, where the signal passed through capacitor 80, clock crystal 82, capacitor 84 and into amplifier 88. A resistor 86 is placed between a 5 volt power supply and the positive input terminal of amp 88 for bias. Feedback resistor 90 is placed between the output of amp 88 and the negative terminal of amp 88. Resistor 92 and capacitor 94 are placed between the negative terminal and ground. The output of amp 96 is fed through a diode, to a low pass filter comprised of resistor 96 and capacitor 98.

The peak detect/comparator circuit 74 receives the output signals from amplifier 88 on conductor 100, where they are fed past resistor 102. Resistor 102 sets the capacitor discharges time constant. The point A at the input terminal to comparator 106 is the point of interest for low battery detection, as discussed below. Resistors 108 and 110 provide a reference voltage at the positive terminal of comparator 106 as shown. The output signal of comparator 106 point B is low when the 32.768 KHZ is present (i.e., the transmitter's oscillator is active and the tones are detected in the circuit 72), and high when the tone is not present. This signal at B is input to the microphone receiver muting circuitry and controls the muting of conventional audio amplification and output circuits (not shown).

Point A in FIG. 3 is essentially a DC voltage proportional to the amplitude of the tone signal from tone oscillator 20 (FIG. 1). When the resistor 42 of FIG. 2 is switched out by transistor 44, as would be the case of a low battery indication from microcontroller 50, the change in amplitude in the tone from oscillator 20 can be detected at point A. Alternatively, if a resistor is not switched in and out of the output of the tone oscillator, the voltage from battery 12 (FIG. 1) supplies the tone oscillator 20 via DC amplifier 24, producing a gradual drop in the amplitude of the tone form the oscillator 20. This change in voltage can also be detected at point A.

Referring to FIG. 10, the negative terminal (conductor 100) of comparator 106 contains a dc voltage that is proportional to the amplitude level of the tone oscillator. This dc voltage then enters a buffer amplifier stage 41 through R1 and R2. R 1 and R2 are used to divide down the dc level, if desired (*i.e*., for flexibility). The buffer is used for isolation purposes; it looks like a high impedance, so it will not load down the signal at conductor 100.

The output of buffer amplifier 41 enters a commercially available analog to digital converter 42, for example, a Texas Instrument Device No. TLC549C. Here, the dc level is converted to a digital signal. This digital signal is monitored by the µC which then updates the LCD display accordingly.

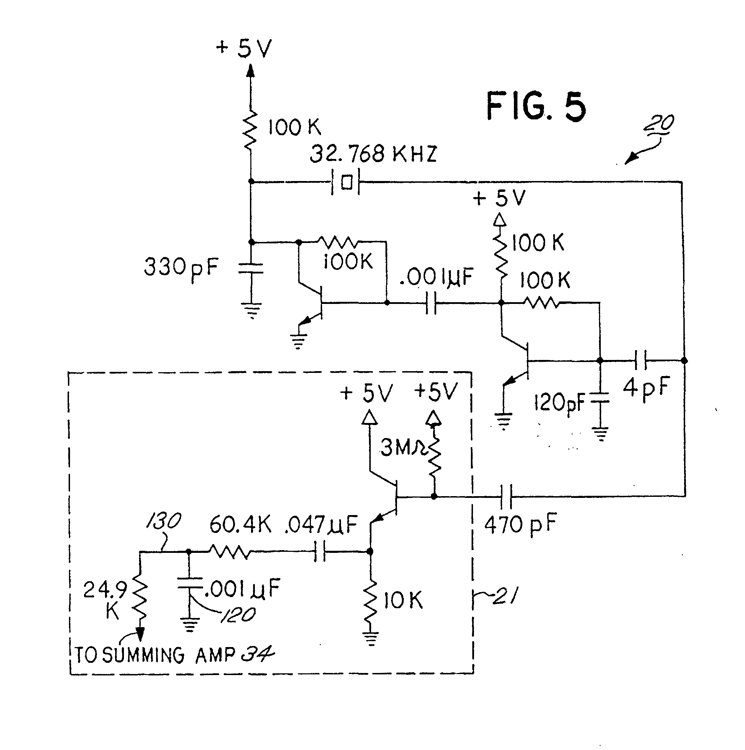

An alternate low battery level detection circuit 76 for detecting these changes in tone amplitude is shown in FIG. 4. The detection circuit 76 includes two sections of an LP339 comparator integrated circuit. This circuit 76 consists of resistors 110, 112, and 114 placed in series from a 12 V power supply, which set reference levels for comparison. The voltage signal at threshold T1 is supplied to the positive terminal of LP339 comparator 116. The voltage signal at threshold T2 is supplied to the negative terminal of comparator 118.

The voltage signal from point A (Fig. 3) is supplied to the negative terminal of comparator 116, and the positive terminal of comparator 118. The comparator outputs are combined at point C, and are tied via a pull-up resistor 117 to +5 volts.

Voltage threshold T1 is set such that when the battery 12 is sufficiently low, the tone's amplitude is reduced such that the voltage at point A falls below threshold T1, thus making the voltage at point C go high. This high signal at point C is fed to a suitable low battery indication circuit. Representative examples of such a circuit would be a microcontroller that operates an LED, or LCD display, or other visual or audible indicator, or a suitable alarm or warning circuit.

In order to keep the low battery indication circuit from not coming on when the transmitter 10 is turned off, a second threshold T2 is set such that when the amplitude of the tone at point A falls below T2 (indicating transmitter 10 is OFF), comparator 118 pulls to ground, sending a low signal at point C to the microcontroller, which tells the indication circuit to not activate the indicator. Many comparators could be used to detect more amplitude levels if greater resolution is desired.

Persons of skill in the art will recognize that other methods of changing the amplitude of the tone signal may be made to indicate a low battery condition in the transmitter. For example, FIG. 5 shows the tone oscillator 20 circuit in the transmitter 10. The amplitude of the tone signal passed to the summing amplifier 34 (FIG. 2) may be varied by switching in and out the filter capacitor 120 in the buffer/filter portion 21 of the tone oscillator 20, as shown in FIG. 6. When a logic high signal is placed at point 122 from microcontroller 50, indicating a low battery condition, transistor 44 is switched on, causing tone level to drop at the input to the summing amp 34. An alternative circuit, shown in FIG. 7, has a resistor R in series with transistor 44, placed in parallel with capacitor 120. Another option would be to let the microcontroller 50 pull the resistor R to ground, instead of using the transistor (see FIG. 9), and similarly with the capacitor. In all of these examples, the goal is simply to change (e.g., reduce) the voltage on the output conductor 130 of the tone oscillator 20 when a low battery condition is present. If the alternative circuit of FIG. 6 is used, the capacitor 120 is part of the RC filter, switching it out may result in the second harmonic of the tone signal being present on the input to the summing amplifier 34, which may be undesirable. Hence, the embodiment of FIG. 2 is preferred to FIGS. 6, 7. and 9, because the RC filter effect of capacitor 120 is preserved. Of course, the simplest choice (and, the one that works best) is running the oscillator as shown in FIG. 1.

The switching of the voltage from tone oscillator 20 from high to low to indicate a low battery condition could be reversed with the voltage switching from low to high. The low battery detection circuit 76 would have to be modified to detect the increase in amplitude indicating a low battery condition.

From the foregoing it will be appreciated that further variations in the details of the best mode and alternative embodiments contemplated by the inventor for practicing the invention, described above, may be made without departure from the true scope of the invention. The choice of particular tone oscillators, tone frequencies, and low battery detection circuits may of course be varied and such variations are within the abilities of persons skilled in the art. Further, alternative circuits that change the amplitude of the tone from the tone oscillator may be readily developed by person of ordinary skill in the art. The true scope of the invention is defined by the appended claims, to be interpreted in light of the foregoing.

## Claims

1. A method of determining the status of a battery (12) in a system comprising a transmitter (10) and a receiver, the transmitter (10) having the battery (12) and the method **characterised by** the steps of:
a) transmitting a tone from said transmitter to said receiver, said tone having a first amplitude associated with said battery being in a normal condition;
b) changing the amplitude of said tone from said first amplitude to a second amplitude when the condition of said battery changes to a low battery condition
c) receiving said tone with said receiver;
d) detecting said change in amplitude of said tone; and
e) responsively alerting a user of said system of the low battery condition of said battery with a quantitative indicator in the form of a battery "fuel gauge" providing essentially a continued monitoring of the battery voltage as it lowers toward a level requiring battery replacement when said amplitude of said tone changes.

2. The method of claim 1 wherein said step of changing the amplitude comprises the step of lowering the amplitude of said tone.

3. The method of claim 1 or 2 wherein said transmitter comprises a wireless microphone transmitter.

4. The method of claim 3 wherein said tone comprises a tone used for tone coded squelch.

5. The method of claim 4 wherein said tone comprises a sine wave having a frequency above the audible limit of a human and preferably wherein said tone comprises a 32.768 Khz sine wave.

6. The method of any preceding claim wherein said tone is generated by a tone oscillator and more preferably a crystal oscillator, and wherein said step of changing the amplitude of said tone comprises the step of changing the amplitude of the output signal from said tone oscillator.

7. A wireless microphone transmitter, comprising:
an audio circuit (14) for receiving sound waves from a sound source and responsively generating an audio signal;
a tone oscillator generating a tone signal, said tone having a first amplitude associated with said battery being in a normal condition and
a summing means (34) for combining said audio signal with said tone signal;
means for changing the amplitude of said tone from a first amplitude to a second amplitude in response to a voltage level of a battery falling below a predetermined threshold; and
an RF circuit (16) for transmitting said summed tone signal and said audio signal.

8. A wireless microphone transmitter according to claim 7, wherein said tone signal is a high frequency tone.

9. A wireless microphone transmitter according to either claim 7 or claim 8, wherein said tone oscillator is suitable for being powered by said battery.

10. A wireless microphone transmitter according to any one of claims 7, 8 or 9 further comprising a DC-DC converter (22) for connection to said battery and for supplying a constant voltage to the transmitter, the said tone oscillator being powered by a source which decreases in power as the voltage level of said battery falls via a DC amplifier (24).

11. A wireless microphone transmitter according to any one of claims 7 to 10 wherein said tone oscillator further comprises an output conductor, and wherein said means for changing the amplitude of said tone includes means powering said tone oscillator.

12. A wireless microphone transmitter according to claim 11 further including:
a microcontroller (50) for connection to said battery and responsively issuing an output signal, said output signal comprising a first signal when said battery voltage is above said predetermined threshold and a second signal when said battery voltage drops below said predetermined threshold;
a transistor (44) coupled to the microcontroller (50) for receiving said first and second output signals from said microcontroller; and
resistance means (42, 46, 38, 48) in circuit with said transistor and said output conductor of said tone oscillator;
whereby said transistor changes the voltage drop across said resistance means in response to said output signal from said microcontroller, causing the output voltage of said tone oscillator on said output conductor to change depending on the condition of said battery.

13. A wireless microphone receiver for receiving signals from a wireless microphone transmitter, comprising:
a detection circuit (78) for detecting and amplifying tones received from said microphone transmitter;
means for detecting (76) when the amplitude of said tones change from a first amplitude to a second amplitude and for indicating this change via a low battery signal; and
means for supplying said low battery signal to an indicator circuit, said indicator circuit activated upon receipt of said low battery signal.

14. A wireless microphone system, comprising a microphone transmitter according to any one of claims 7 to 12, and a wireless microphone receiver according to claim 13.

## Patentansprüche

1. Verfahren zum Ermitteln des Zustands einer Batterie (12) in einem System, das einen Sender (10) und einen Empfänger umfaßt, wobei der Sender (10) die Batterie (12) enthält, und wobei das Verfahren **gekennzeichnet ist durch** die Schritte:
a) Senden eines Tons von Sender zum Empfänger, wobei der Ton eine erste Amplitude aufweist, die der in einem Normalzustand befindlichen Batterie zugeordnet ist;
b) Ändern der Amplitude des Tons ausgehend von der ersten Amplitude zu einer zweiten Amplitude, wenn sich der Zustand der Batterie in einen Batterie-Schwach-Zustand ändert;
c) Empfangen des Tons mit dem Empfänger;
d) Erfassen der Amplitudenänderung des Tons; und
e) entsprechendes Alarmieren eines Benutzers des Systems über den Batterie-Schwach-Zustand der Batterie mit einem quantitativen Indikator in Form eines Batterie-"lnhaltsanzeigers", der im wesentlichen eine fortgesetzte Überwachung der Batteriespannung bietet, wenn sich diese in Richtung eines Pegels verringert, der einen Austausch der Batterie erfordert, wenn sich die Amplitude des Tons ändert.

2. Verfahren nach Anspruch 1, bei dem der Schritt der Änderung der Amplitude den Schritt des Senkens der Amplitude des Tons umfaßt.

3. Verfahren nach Anspruch 1 oder 2, bei dem der Sender einen drahtlosen Mikrophonsender umfaßt.

4. Verfahren nach Anspruch 3, bei dem der Ton einen Ton umfaßt, der für eine Ton-codierte Rauschunterdrückung verwendet wird.

5. Verfahren nach Anspruch 4, bei dem der Ton eine Sinuswelle umfaßt, die eine Frequenz oberhalb der Hörgrenze eines Menschen aufweist, wobei der Ton vorzugsweise eine Sinuswelle mit 32,768 kHz aufweist.

6. Verfahren nach irgendeinem der vorangehenden Ansprüche, bei dem der Ton von einem Tonoszillator, vorzugsweise einem Kristalloszillator, erzeugt wird, wobei der Schritt des Änderns der Amplitude des Tons den Schritt des Änderns der Amplitude des Ausgangssignals vom Tonoszillator umfaßt.

7. Drahtloser Mikrophonsender, umfassend:
eine Audioschaltung (14) zum Empfangen von Schallwellen von einer Schallquelle und zum entsprechenden Erzeugen eines Audiosignals;
einen Tonoszillator, der ein Tonsignal erzeugt, wobei der Ton eine erste Amplitude aufweist, die einer in einem Normalzustand befindlichen Batterie zugeordnet ist;
ein Summierungsmittel (34) zum Kombinieren des Audiosignals mit dem Tonsignal;
Mittel zum Ändern der Amplitude des Tons ausgehend von einer ersten Amplitude zu einer zweiten Amplitude in Reaktion auf einen Spannungspegel einer Batterie, der unter eine vorgegebene Schwelle fällt; und
eine HF-Schaltung (16) zum Senden des summierten Tonsignals und Audiosignals.

8. Drahtloser Mikrophonsender nach Anspruch 7, bei dem das Tonsignal ein Hochfrequenzton ist.

9. Drahtloser Mikrophonsender nach Anspruch 7 oder Anspruch 8, bei dem der Tonoszillator dafür geeignet ist, batteriebetrieben zu sein.

10. Drahtloser Mikrophonsender nach irgendeinem der Ansprüche 7, 8 oder 9, der ferner einen Gleichspannungswandler (22) für die Verbindung mit der Batterie und zum Zuführen einer konstanten Spannung zum Sender umfaßt, wobei der Tonoszillator über einen Gleichspannungsverstärker (24) mittels einer Quelle betrieben wird, die in der Leistung abnimmt, wenn der Spannungspegel der Batterie absinkt.

11. Drahtloser Mikrophonsender nach irgendeinem der Ansprüche 7 bis 10, bei dem der Tonoszillator ferner einen Ausgangsleiter umfaßt, und wobei das Mittel zum Ändern der Amplitude des Tons Mittel zum Betreiben des Tonoszillators umfaßt.

12. Drahtloser Mikrophonsender nach Anspruch 11, der ferner enthält:
einen Mikrocontroller (50) für die Verbindung mit der Batterie und zum entsprechenden Ausgeben eines Ausgangssignals, wobei das Ausgangssignal ein erstes Signal, wenn die Batteriespannung über der vorgegebenen Schwelle liegt, und ein zweites Signal umfaßt, wenn die Batteriespannung unter die vorgegebene Schwelle absinkt;
einen Transistor (44), der mit dem Mikrocontroller (50) verbunden ist, um die ersten und zweiten Ausgangsslgnale vom Mikrocontroller zu empfangen; und
Widerstandsmittel (42, 46, 38, 48) in der Schaltung mit dem Transistor und dem Ausgangsleiter des Tonoszillators;
wobei der Transistor den Spannungsabfall über den Widerstandsmitteln in Reaktion auf das Ausgangssignal vom Mikrocontroller ändert, wodurch die Ausgangsspannung des Tonoszillators am Ausgangsleiter veranlaßt wird, sich in Abhängigkeit vom Zustand der Batterie zu ändern.

13. Drahtloser Mikrophonempfänger zum Empfangen von Signalen von einem drahtlosen Mikrophonsender, umfassend:
eine Erfassungsschaltung (78) zum Erfassen und Verstärken von Tönen, die vom Mikrophonsender empfangen werden;
Mittel zum Erfassen (76), wenn sich die Amplitude der Töne von einer ersten Amplitude zu einer zweiten Amplitude ändern, und zum Anzeigen dieser Änderung über ein Batterie-Schwach-Signal; und
Mittel zum Zuführen eines Batterie-Schwach-Signals zu einer Anzeigeschaltung, wobei die Anzeigeschaltung bei Empfang des Batterie-Schwach-Signals aktiviert wird.

14. Drahtloses Mikrophonsystem, das einen Mikrophonsender nach irgendeinem der Ansprüche 7 bis 12 und einen drahtlosen Mikrophonempfänger nach Anspruch 13 umfaßt.

## Revendications

1. Procédé pour déterminer l'état d'une pile (12) dans un système qui comprend un émetteur (10) et un récepteur, l'émetteur (10) comprenant la pile (12) et le procédé étant **caractérisé par** les étapes de :
a) émission d'une tonalité par ledit émetteur vers ledit récepteur, ladite tonalité ayant une première amplitude associée à ladite pile se trouvant dans une condition normale ;
b) changement de l'amplitude de ladite tonalité de ladite première amplitude vers une seconde amplitude quand la condition de ladite pile change pour une condition de pile faible ;
c) réception de ladite tonalité par ledit récepteur ;
d) détection dudit changement de l'amplitude de ladite tonalité ; et
e) alerte de manière réactive d'un utilisateur dudit système de la condition de pile faible de ladite pile par un indicateur quantitatif sous la forme d'un « indicateur de niveau » de pile qui fournit sensiblement une surveillance continue de la tension de la pile pendant qu'elle baisse vers un niveau qui requiert le remplacement de la pile quand ladite amplitude de ladite tonalité change.

2. Procédé selon la revendication 1, dans lequel ladite étape de changement de l'amplitude comprend l'étape d'abaissement de l'amplitude de ladite tonalité.

3. Procédé selon la revendication 1 ou 2, dans lequel ledit émetteur comprend un émetteur de microphone sans fil.

4. Procédé selon la revendication 3, dans lequel ladite tonalité comprend une tonalité utilisée pour un silencieux codé par tonalité.

5. Procédé selon la revendication 4, dans lequel ladite tonalité comprend une onde sinusoïdale ayant une fréquence supérieure à la limite audible par un être humain et de préférence dans lequel ladite tonalité comprend une onde sinusoïdale de 32,768 kHz.

6. Procédé selon l'une quelconque des revendications précédentes, dans lequel ladite tonalité est produite par un oscillateur de tonalité et de manière plus préférée par un oscillateur à quartz, et dans lequel ladite étape de changement de l'amplitude de ladite tonalité comprend l'étape de changement de l'amplitude du signal de sortie délivré par ledit oscillateur de tonalité.

7. Émetteur de microphone sans fil, comprenant :
un circuit audio (14) pour recevoir des ondes sonores délivrées par une source sonore et produire de manière réactive un signal audio ;
un oscillateur de tonalité produisant un signal de tonalité, ladite tonalité ayant une première amplitude associée à ladite pile se trouvant dans une condition normale ; et
des moyens de sommation (34) pour associer ledit signal audio audit signal de tonalité ;
des moyens pour changer l'amplitude de ladite tonalité à partir d'une première amplitude vers une seconde amplitude en réponse à un niveau de tension d'une pile qui tombe en dessous d'un seuil prédéterminé ; et
un circuit HF (16) pour émettre ledit signal de tonalité et ledit signal audio sommés.

8. Émetteur de microphone sans fil selon la revendication 7, dans lequel ledit signal de tonalité est à une fréquence de tonalité élevée.

9. Émetteur de microphone sans fil selon la revendication 7 ou la revendication 8, dans lequel ledit oscillateur de tonalité est approprié pour être alimenté par ladite pile.

10. Émetteur de microphone sans fil selon l'une quelconque des revendications 7, 8 ou 9, comprenant de plus un convertisseur DC - DC (22) destiné à être connecté à ladite pile et à fournir une tension constante à l'émetteur, ledit oscillateur de tonalité étant alimenté par une source qui décroît en puissance quand le niveau de la tension de ladite pile tombe, par l'intermédiaire d'un amplificateur DC (24).

11. Émetteur de microphone sans fil selon l'une quelconque des revendications 7 à 10, dans lequel ledit oscillateur de tonalité comprend de plus un conducteur de sortie, et dans lequel lesdits moyens de changement de l'amplitude de ladite tonalité comprennent des moyens d'alimentation dudit oscillateur de tonalité.

12. Émetteur de microphone sans fil selon la revendication 11, comprenant de plus :
un microcontrôleur (50) destiné à être connecté à ladite pile et délivrant de manière réactive un signal de sortie, ledit signal de sortie comprenant un premier signal quand la tension de ladite pile se situe au-dessus dudit seuil prédéterminé et un second signal quand la tension de ladite pile chute en dessous dudit seuil prédéterminé ;
un transistor (44) couplé au microcontrôleur (50) pour recevoir lesdits premier et second signaux de sortie délivrés par ledit microcontrôleur, et
des moyens de résistance (42, 48, 38, 48) reliés en circuit avec ledit transistor et ledit conducteur de sortie dudit oscillateur de tonalité ;
grâce à quoi ledit transistor modifie la chute de tension aux bornes desdits moyens de résistance en réponse audit signal de sortie dudit microcontrôleur, en provoquant un changement de la tension de sortie dudit oscillateur de tonalité sur ledit conducteur de sortie, selon la condition de ladite pile.

13. Récepteur de microphone sans fil pour recevoir les signaux délivrés par un émetteur de microphone sans fil, comprenant :
un circuit de détection (78) pour détecter et amplifier des tonalités reçues à partir dudit émetteur de microphone ;
des moyens pour détecter (76) quand l'amplitude desdites tonalités change à partir d'une première amplitude vers une seconde amplitude et pour indiquer ce changement par l'intermédiaire d'un signal de pile faible ; et
des moyens pour fournir ledit signal de pile faible à un circuit indicateur, ledit circuit indicateur étant activé au moment de la réception dudit signal de pile faible.

14. Système de microphone sans fil, comprenant un émetteur de microphone selon l'une quelconque des revendications 7 à 12, et un récepteur de microphone sans fil selon la revendication 13.
